# EUROPEAN PATENT SPECIFICATION

(11) **EP 1 126 565 B1**
(45) Date of publication and mention of the grant of the patent: **29.10.2003**
(21) Application number: 01103249.7
(22) Date of filing: 12.02.2001
(51) Int. Cl.: H01R 43/02

(54) **Casing for an electronic unit**
Gehäuse für eine elektronische Einheit
Boîtier pour une unité électronique

(30) Priority: 14.02.2000 JP 2000034583
(43) Date of publication of application: 22.08.2001
(73) Proprietor: Autonetworks Technologies, Ltd., Nagoya-shi, Aichi (JP); SUMITOMO WIRING SYSTEMS, Ltd., Yokkaichi-shi, Mie-ken 510 (JP); SUMITOMO ELECTRIC INDUSTRIES, LTD., Osaka-shi, Osaka (JP)
(72) Inventor: Hiramatsu, Shinya, AutoNetworks Technologies, Ltd., Nagoya-shi, Aichi-ken (JP)
(74) Representative: Kuhnen & Wacker

(56) References cited:
- US-A- 5 850 693
- US-A- 6 007 366

## Description

### BACKGROUND OF THE INVENTION

### 1. Field of the Invention

The present invention relates to a casing for an electronic unit used in electronic circuits etc. for automobiles.

### 2. Description of the Related Art

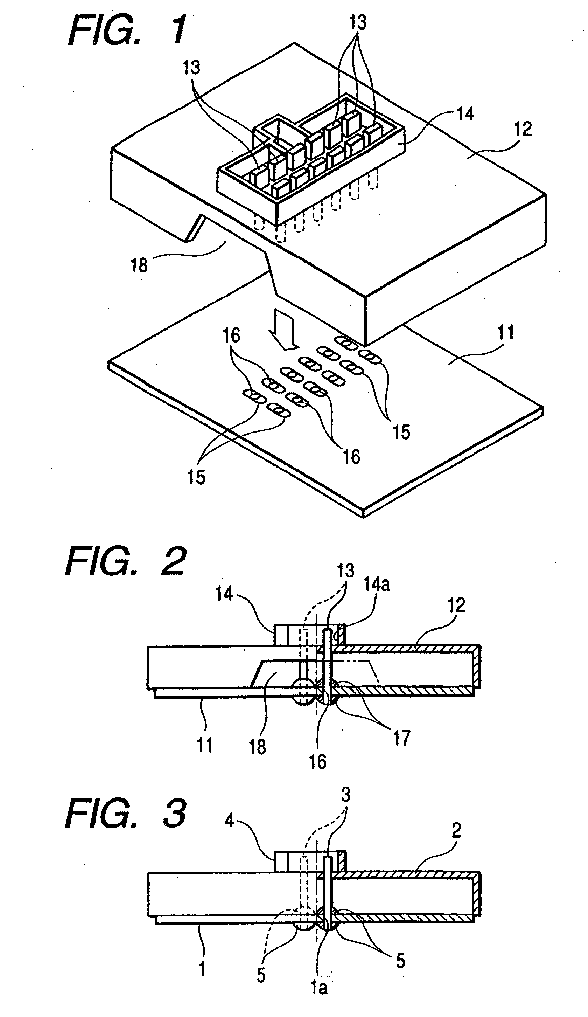

An electronic unit of this kind, as shown in Fig. 3, includes a printed board 1, an open-bottomed casing 2 which accommodates the printed board 1 by fitting over the board 1 from above, and a plurality of connector terminals (male terminals) 3··· which are electrically coupled to the printed board 1 by soldering. Reference numeral 4 depicts a connector housing integrally provided on the top surface side of the casing 2.

Conventionally, in this electronic unit, for the purposes of reducing the number of parts etc., a casing in which the connector terminals 3 ··· are integrated with the casing 2 (connector terminal integrated electronic unit casing) has been adopted.

When this connector terminal integrated casing is employed, a process is used by which the connector terminals 3··· are soldered to the board 1 in a state where the casing 2 is fitted over the board 1.

Further, as for the actual working process when this connector terminal integrated casing is employed, for example, a process is used by which a suitable amount of solder material is set on each of through hole 1a portions, then the connector terminals 3··· are inserted into the through holes, and in this state the solder material is melted and fused to the terminals 2 and the board 1.

However, when this connector terminal integrated casing is employed, since the casing 2 is already fitted over the board 1 at the stage of soldering and so the portions to be soldered are concealed by the casing 2, the solder finish state after the soldering process cannot be visually checked.

Consequently, there is a possibility of shipment with soldering defects, if any, overlooked. It can also be considered that the solder finish state is inspected with inspection apparatus. In this way, however, the addition of equipment and process will cause an increase in cost.

In US Patent No. 6,007,366 a non-generic casing for an electronic unit is disclosed onto which a printed board is accommodated. A recess or window extends along the connector terminals arranged in a row. Therefore, the more the number of terminals in the casing as disclosed in US Patent No. 6,007,366 increases, the more the size of the window is widened. Considering the incursion of dust and the protection of the internal electronic devices, it is a great disadvantage of this casing that the size of the window gets wider the more the number of terminals increases.

### SUMMARY OF THE INVENTION

Accordingly, an object of the invention is to provide, in the connector terminal integrated casing, a casing for an electronic unit in which the solder finish state can be visually checked from the outside.

To achieve the above object, according to a first aspect of the invention, there is provided a casing for an electronic unit in which a printed board is accommodated and a connector terminal coupled'to the printed board by soldering is provided, wherein a window through which a soldered portion where the connector terminal is soldered to the printed board can be checked by observing from the outside.

According to a second aspect of the invention, in the arrangement of the above first aspect, the window is provided at a side surface portion which faces the soldered portion where the connector terminal is soldered to the printed board.

According to a third aspect of the invention, in the arrangement of the above second aspect, the window is formed as a notch cut open in the underside of the casing.

According to the aforesaid arrangement, since the soldered portions within the casing can be observed through the window from the outside, even in an electronic unit in which the soldered portions are covered with a casing, the solder finish state can be checked at one glance.

In this case, according to the arrangement of the second aspect, since the window is provided at the side surface portion, as compared with a case where a window-is provided at the top surface portion, the solder finish state can be visually checked with accuracy by observing the soldered portions located on the bottom surface side of the case from the side surface portion close to the soldered portions. The advantageous effect on this point becomes especially noticeable in an electronic unit in which a multiplicity of connector terminals are provided with small pitches.

Also, when this window at the side surface portion of the casing is formed as a notch cut open in the underside of-the casing according to the third aspect, the soldered portions inside the casing become easier to observe from the outside.

### BRIEF DESCRIPTION OF THE DRAWINGS

Fig. 1 is a perspective view of a casing and a printed board according to the embodiment of the invention;
Fig. 2 is a semi fragmentary sectional view in a state where the casing and the printed board are assembled; and
Fig. 3 is a semi fragmentary sectional view in a state where a conventional casing and a printed board are assembled.

### DETAILED DESCRIPTION OF THE PREFERRED EMBODIMENTS

An embodiment of the invention will be explained with reference to Figs. 1 and 2.

In Figs. 1 and 2, reference numeral 11 depicts a printed board, 12 an open-bottomed casing, and 13 a multiplicity of connector terminals.

These connector terminals 13 are integrally provided on the casing 12 in a manner that the terminals extend through the bottom wall of a connector housing 14 integrally provided on the casing 12, the upper portions of the terminals are located within the housing 14, and the lower end portions of the terminals are located in the opening of the bottom surface of the casing.

Also, according to the embodiment, the connector terminals 13 are arranged in double file with regular pitches. In Fig. 2, reference numeral 14a depicts a terminal through hole provided at the bottom wall of the connector housing 14.

The printed board 11 is provided with lands (conductive portions) 15 in correspondence with the connector terminals 13, and through holes 16 at the center portions of these lands 15, respectively. At the time of assembling the unit, in a state where the casing 12 is fitted over the board 11, the lower end portion of each of the connector terminals 13 is inserted into the corresponding through hole 16 and soldered to the board 11 at the both ends of the through hole. In Fig. 2, reference numerals 17 depict the soldered portions.

At one side surface portion of the casing 12, specifically, at the side surface portion facing the two terminals 13, at the end of the connector terminals arranged in double file, a window 18 through which the soldered portions 17 can be visually checked from the outside is formed as a notch cut open in the underside of the casing.

Therefore, according to this arrangement, since the soldered portions 17 within the casing 12 (covered with the casing 12) can be observed through the window 18 from the outside, the solder finish state can be checked at one glance.

Also, since the window 18 is provided at the side surface portion of the casing, as compared with a case where a window is provided at the upper surface portion, particularly, even when a multiplicity of the connector terminals 13 are provided with small pitches as in the embodiment, the solder finish state can be visually checked with accuracy by observing the soldered portions 17 located on the bottom surface side of the casing from the side surface portion close to the soldered portions.

Further, since the window 18 at the side surface portion of the. casing is formed as the notch cut open in the underside of the casing and the soldered portions 17 can be observed from the same level as that of the soldered portions, the soldered portions 17 inside the casing become easier to observe from the outside.

On the other hand, the window 18 maybe formed as an opening closed on all sides instead of the notch as in the embodiment. Also, the window 18 may be provided at the upper surface portion. Further, the window may be provided not only at one portion but at a plurality of portions at the side surface portion or the upper surface portion.

As described above, according to the casing for the electronic unit of the invention, since there is provided the window through which the soldered portions where the connector terminals are soldered to the printed board can be visually checked from the outside, the solder finish state can be checked at one glance even in an electronic unit in which the soldered portions are covered with the casing.

Consequently, there is no possibility of shipment with any soldering defects overlooked. Further, since there is added no inspection process on the solder finish state with inspection apparatus, no increase in cost will be involved.

In this case, according to the second aspect of the invention, since the window is provided at the side surface portion, as compared with a case where a window is provided at the upper surface portion, the solder finish state can be visually checked with accuracy by observing the soldered portions located on the bottom surface side of the casing from the side surface portion close to the soldered portions. The advantageous effect on this point becomes especially noticeable in an electronic unit in which a multiplicity of connector terminals are provided with small pitches.

Also, according to the third aspect of the invention, since the window at the side surface portion of the casing is formed as a notch cut open in the underside of the casing, the soldered portions inside the casing become easier to observe from the outside.

## Claims

1. An open-bottomed casing (12) for an electronic unit in which a printed board (11) is accommodated by fitting the casing (12) over the printed board (11) from above and a connector terminal (13) coupled to said printed board by soldering is provided, said casing (12) comprising:
- a connector housing (14) integrally provided on the top surface side of the casing (12),
- wherein said connector terminals (13) are integrally provided on the casing (12) and which are arranged in a row in a predetermined direction, and
- a window (18) through which a soldered portion (17) where said connector terminals (13) are soldered to said printed board (11) can be checked by observing from outside in the predetermined direction, so that a soldering state can be recognized after the connector terminal integrated casing (12) is inserted into the substrate and soldered,
- wherein the window (18) is formed so as to face an end of the row of the connector terminals.

2. The casing (12) for an electronic unit according to claim 1, wherein said window (18) is provided at a side surface portion which faces said soldered portion where said connector terminal (13) is soldered to said printed board (11).

3. The casing (12) for an electronic unit according to claim 2, wherein said window (18) is formed as a notch cut open in the underside of said casing (12).

## Patentansprüche

1. Ein am Boden geöffnetes Gehäuse (12) für eine elektronische Einheit, in welchem eine Leiterplatine (11) aufgenommen ist durch Befestigen des Gehäuses (12) über der Leiterplatine (11) von oben, wobei ein Verbinderanschluß (13), welcher mit der Leiterplatine durch Löten verbunden ist, vorgesehen ist, wobei das Gehäuse (12) aufweist:
- ein Verbindergehäuse (14), welches integral an der oberen Fläche des Gehäuses (12) vorgesehen ist,
- wobei die Verbinderanschlüsse (13) integral am Gehäuse (12) vorgesehen und in einer Reihe in einer vorbestimmten Richtung angeordnet sind, und
- ein Fenster (18), durch welches ein Lötabschnitt (11), an welchem die Verbinderanschlüsse (13) an die Leiterplatine (11) gelötet sind, durch Beobachtung von außen in der vorbestimmten Richtung derart geprüft werden können, daß ein Lötzustand nach dem Einfügen des Gehäuses (12) mit den integrierten Verbinderanschlüssen in den Träger eingefügt und festgelötet ist, erkannt werden kann,
- wobei das Fenster (18) ausgestaltet ist, um einem Ende der Reihe der Verbinderanschlüsse zugewandt zu liegen.

2. Gehäuse (12) für eine elektrische Einheit nach Anspruch 1, bei welchem das Fenster (18) an einem Seitenflächenabschnitt vorgesehen ist, welcher dem Lötabschnitt zugewandt liegt, an welchem der Verbinderanschluß (13) an die Leiterplatine (11) gelötet ist.

3. Gehäuse (12) für eine elektronische Einheit nach Anspruch 2, wobei das Fenster (18) als eine aufgeschnittene Aussparung an der Unterseite des Gehäuses (12) ausgestaltet ist.

## Revendications

1. Boîtier à fond ouvert (12) pour une unité électronique dans lequel une carte de circuits imprimés (11) est logée en ajustant le boîtier (12) au-dessus de la carte de circuits imprimés (11) par le haut et une borne de connecteur (13) couplée par soudage à ladite carte de circuits imprimés est prévue, ledit boîtier (12) comprenant :
- un logement de connecteur (14) placé d'un seul tenant sur la face supérieure du boîtier (12) ;
- dans lequel lesdites bornes de connecteur (13) sont placées d'un seul tenant sur le boîtier (12) et sont agencées en une rangée dans une direction prédéterminée, et
- une fenêtre (18) par laquelle une partie soudée (17) où lesdites bornes de connecteur (13) sont soudées à ladite carte de circuits imprimés (11) peut être contrôlée en observant de l'extérieur dans la direction prédéterminée, de façon à pouvoir identifier un état du soudage après que le boîtier intégré à bornes de connecteur (12) a été inséré dans le substrat et soudé,
- dans lequel la fenêtre (18) est formée de façon à faire face à une extrémité de la rangée des bornes de connecteur.

2. Boîtier (12) pour une unité électronique selon la revendication 1, dans lequel ladite fenêtre (18) est placée sur une partie de surface latérale qui fait face à ladite partie soudée où ladite borne de connecteur (13) est soudée à ladite carte de circuits imprimés (11).

3. Boîtier (12) pour une unité électronique selon la revendication 2, dans lequel ladite fenêtre (18) est formée comme une encoche découpée dans la partie inférieure dudit boîtier (12).
